# EUROPÄISCHE PATENTANMELDUNG

(11) **EP 1 614 734 A1**
(43) Veröffentlichungstag der Anmeldung: **11.01.2006**
(21) Anmeldenummer: 05104984.9
(22) Anmeldetag: 08.06.2005
(51) Int. Cl.: C09J 7/00, C09J 7/02, C09J 153/00, C09J 163/00

(54) **Hitzeaktivierbares Klebeband für die Verklebung von elektronischen Bauteilen und Leiterbahnen**

(30) Priorität: 28.06.2004 DE 102004031188
(71) Anmelder: tesa AG, 20253 Hamburg (DE)
(72) Erfinder: Krawinkel, Thorsten Dr., 22457, Hamburg (DE); Ring, Christian, 20259, Hamburg (DE)
(74) Vertreter: Stubbe, Andreas

(57) **Zusammenfassung**

Hitzeaktivierbares Klebeband für die Verklebung von elektronischen Bauteilen und Leiterbahnen mit einer Klebemasse, die zumindest aus
a) einem säure- oder säureanhydridmodifizierten Vinylaromatenblockcopolymer und
b) einer epoxidhaltigen Verbindung
besteht.

## Beschreibung

Die Erfindung betrifft eine hitzeaktivierbare Klebmasse mit geringem Fließvermögen bei hohen Temperaturen zur Verklebung von elektronischen Bauteilen und von flexiblen gedruckten Leiterbahnen (Flexible Printed Circuit Boards, FPCBs).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine sehr schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen, für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig Elastomere zu finden, die langkettig genug sind, um bei hohen Temperaturen nicht zu fließen, andererseits aber noch so kurzkettig sind, dass sie in Lösung gebracht werden können.

Eine Herstellung über einen Hotmelt-Prozess ist bei vernetzenden Systemen nur sehr schwierig möglich, da eine frühzeitige Vernetzung während des Herstellprozesses vermieden werden muss.

Der Stand der Technik offenbart des Weiteren in der WO 00/01782 A1 eine elektrisch leitfähige, thermoplastische und hitzeaktivierbare Klebstofffolie, enthaltend
i) ein thermoplastisches Polymer mit einem Anteil von 30 bis 89,9 Gew.-%,
ii) ein oder mehrere klebrigmachende Harze mit einem Anteil von 5 bis 50 Gew.-% und/oder
iii) Epoxydharze mit Härtern, gegebenenfalls auch Beschleunigern, mit einem Anteil von 5 bis 40 Gew.-%,
iv) versilberte Glaskugeln oder Silberpartikel mit einem Anteil von 0,1 bis 40 Gew.-%.

Eine Weiterentwicklung ist aus der DE 198 53 805 A1 bekannt geworden mit der elektrisch leitfähigen, thermoplastischen und hitzeaktivierbaren Klebstofffolie, die enthält
i) ein thermoplastisches Polymer mit einem Anteil von zumindest 30 Gew.-%,
ii) ein oder mehrere klebrigmachende Harze mit einem Anteil von 5 bis 50 Gew.-% und/oder
iii) Epoxydharze mit Härtern, gegebenenfalls auch Beschleunigern, mit einem Anteil von 5 bis 40 Gew.-%,
iv) metallisierte Partikel mit einem Anteil von 0,1 bis 40 Gew.-%,
v) nur schwer oder nicht verformbare Spacerpartikel mit einem Anteil von 1 bis 10 Gew.-%, die bei der Verklebungstemperatur der Klebstofffolie nicht schmelzen.

Nach bevorzugten Ausführungsformen handelt es sich bei den thermoplastischen Polymeren jeweils um thermoplastische Polyolefine, Polyester, Polyurethane oder Polyamide oder modifizierte Kautschuke, wie insbesondere Nitrilkautschuke.

Aufgabe der Erfindung ist es somit, ein Klebeband bereitzustellen, das hitzeaktivierbar ist, in der Hitze vernetzt, eine geringe Viskosität in der Hitze besitzt, gute Haftung auf Polyimid zeigt und im unvernetzten Zustand löslich in organischen Lösungsmitteln ist.

Gelöst wird diese Aufgabe überraschend durch ein Klebeband, wie es in dem Hauptanspruch näher gekennzeichnet ist. Gegenstand der Unteransprüche sind vorteilhafte Weiterentwicklungen des Erfindungsgegenstandes.

Demgemäß ist Gegenstand der Erfindung ein Klebeband für die Verklebung von elektronischen Bauteilen und flexiblen Leiterbahnen, umfassend eine Klebmasse, bestehend mindestens aus einem säure- oder säureanhydridmodifizierten Vinylaromatenblockcopolymer und einem Epoxidharz.

Der allgemeine Ausdruck "Klebeband" umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Klebmassen auf Basis von säureanhydridmodifizierten Blockcopolymeren und Epoxidharzen sind bekannt aus US 5,369,167 A. Beschrieben wird eine Herstellungsmethode dieser Compounds. Es werden zudem Härter eingesetzt für die Vernetzung des Epoxidharzes. Ein Klebeband wird nicht erwähnt.

Ähnliche Klebmassen sind auch in JP 57/149369 A1 beschrieben. Wieder wird ein Härter für das Epoxidharz benötigt. Ein Klebeband ist nicht näher beschrieben.

Vorteil der erfindungsgemäßen Klebmassen ist, dass das Elastomer tatsächlich chemisch mit dem Harz vernetzt, eine Zugabe eines Härters für das Epoxidharz ist nicht notwendig, da das Elastomer selbst als Härter wirkt.

Als Klebemassen finden bevorzugt solche auf Basis von Blockcopolymeren enthaltend Polymerblöcke überwiegend gebildet von Vinylaromaten (A-Blöcke), bevorzugt Styrol, und solchen überwiegend gebildet durch Polymerisation von 1,3-Dienen (B-Blöcke), bevorzugt Butadien und Isopren Anwendung. Sowohl Homo- als auch Copolymerblöcke sind erfindungsgemäß nutzbar. Resultierende Blockcopolymere können gleiche oder unterschiedliche B-Blöcke enthalten, die teilweise, selektiv oder vollständig hydriert sein können. Blockcopolymere können lineare A-B-A Struktur aufweisen. Einsetzbar sind ebenfalls Blockcopolymere von radialer Gestalt sowie sternförmige und lineare Multiblockcopolymere. Als weitere Komponenten können A-B Zweiblockcopolymere vorhanden sein. Blockcopolymere von Vinylaromaten und Isobutylen sind ebenfalls erfindungsgemäß einsetzbar. Sämtliche der vorgenannten Polymere können alleine oder im Gemisch miteinander genutzt werden.
Zumindest ein Teil der eingesetzten Blockcopolymere muss dabei säure- oder säureanhydridmodifiziert sein, wobei die Modifizierung hauptsächlich durch radikalische Pfropfcopolymerisation von ungesättigten Mono- und Polycarbonsäuren oder -säureanhydriden, wie zum Beispiel Fumarsäure, Itaconsäure, Citraconsäure, Acrylsäure, Maleinsäureanhydrid, Itaconsäureanhydrid oder Citraconsäureanhydrid, bevorzugt Maleinsäureanhydrid erfolgt. Bevorzugt liegt der Anteil an Säure beziehungsweise Säureanhydrid zwischen 0,5 und 4 Gewichtsprozenten bezogen auf das gesamte Blockcopolymer.

Kommerziell sind solche Blockcopolymere zum Beispiel unter dem Namen Kraton™ FG 1901 und Kraton™ FG 1924 der Firma Shell, beziehungsweise Tuftec™ M 1913 und Tuftec™ M 1943 der Firma Asahi erhältlich.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden sind verwendbar. Ebenfalls sind elastisch modifizierte Epoxidharze einsetzbar oder epoxidmodifizierte Elastomere wie zum Beispiel epoxidierte Styrolblockcopolymere, zum Beispiel Epofriend der Firma Daicel.

Beispiele von Epoxidharzen sind Araldite™ 6010 , CY-281™, ECN™ 1273, ECN™ 1280, MY 720, RD-2 von Ciba Geigy, DER™ 331, 732, 736, DEN™ 432 von Dow Chemicals, Epon™ 812, 825, 826, 828, 830 etc. von Shell Chemicals, HPY™ 1071, 1079 ebenfalls von Shell Chemicals, Bakelite™ EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Elastomere sind erhältlich von der Firma Noveon unter dem Namen Hycar.

Epoxidverdünner, monomere Verbindungen mit mehreren Epoxidgruppen sind zum Beispiel Bakelite™ EPD KR, EPD Z8, EPD HD, EPD WF, etc. der Bakelite AG oder Polypox™ R 9, R12, R 15, R 19, R 20 etc. der Firma UCCP.

Obwohl wie oben beschrieben die Zugabe von Vernetzern nicht nötig ist, können trotzdem weitere Härter zugesetzt werden. Als Härter sollten hier nur Stoffe mit Säure- oder Säureanhydridgruppen eingesetzt werden, da die hauptsächlich für Epoxidvernetzung eingesetzten Amine und Guanidine mit dem Säureanhydrid reagieren und damit die Anzahl der reaktiven Gruppen herabsetzt.

Neben den schon genannten säure- oder säureanhydridmodifizierten Vinylaromatenblockcopolymeren können auch noch weitere Säuren oder Säureanhydride zugesetzt werden, um einen höheren Vernetzungsgrad und damit eine noch weiter verbesserte Kohäsion zu erreichen. Dabei sind sowohl monomere Säureanhydride und Säuren wie in US 3,970,608 A beschrieben als auch säure- oder säureanhydridmodifizierte Polymere als auch säureanhydridenthaltende Copolymere wie Polyvinylmethylether-maleinsäureanhydrid-Copolymere, zum Beispiel zu beziehen unter dem Namen Gantrez™, vertrieben von der Firma ISP, einsetzbar.

Durch die chemische Vernetzung der Harze mit den Elastomeren werden sehr große Festigkeiten innerhalb des Klebefilms erreicht. Aber auch die Verklebungsfestigkeiten zum Polyimid sind ausgesprochen hoch.

Um die Adhäsion zu erhöhen, ist auch der Zusatz von mit dem Elastomerblock der Blockcopolymere verträglichen Klebharzen möglich.

Als Klebrigmacher können in erfindungsgemäßen Haftklebemassen zum Beispiel nicht hydrierte, partiell- oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C₅-, C₅/C₉-oder C₉-Monomerströmen, Polyterpenharze auf Basis von α-Pinen und/oder ß-Pinen und/oder δ-Limonen, hydrierte Polymerisate von bevorzugt reinen C₈- und C₉-Aromaten eingesetzt werden. Vorgenannte Klebharze können sowohl allein als auch im Gemisch eingesetzt werden.

Als weitere Additive können typischerweise genutzt werden:
- primäre Antioxidanzien, wie zum Beispiel sterisch gehinderte Phenole
- sekundäre Antioxidanzien, wie zum Beispiel Phosphite oder Thioether
- Prozessstabilisatoren, wie zum Beispiel C-Radikalfänger
- Lichtschutzmittel, wie zum Beispiel UV-Absorber oder sterisch gehinderte Amine
- Verarbeitungshilfsmittel
- Endblockverstärkerharze
- Füllstoffe, wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller
- gegebenenfalls weitere Polymere von bevorzugt elastomerer Natur.

Vorteilhaft an diesen Systemen ist die sehr niedrige Erweichungstemperatur, die sich aus dem Erweichungspunkt des Polystyrols in den Endblöcken der Blockcopolymere ergibt. Da die Elastomere bei der Vernetzungsreaktion mit in ein polymeres Netzwerk eingebunden werden und diese Reaktion bei den hohen Temperaturen von bis zu 200 °C, die üblicherweise für die Verklebung von FPCBs verwendet werden, relativ schnell ist, kommt es nicht zu Austritten der Klebmasse aus der Klebfuge. Durch die Zugabe von so genannten Beschleunigern kann die Reaktionsgeschwindigkeit weiter erhöht werden.
Beschleuniger können zum Beispiel sein:
- tertiäre Amine, wie Benzyldimethylamin, Dimethylaminomethylphenol, Tris(dimethylaminomethyl)phenol
- Bortrihalogenid-Amin-Komplexe
- substituierte Imidazole
- Triphenylphosphin

Idealerweise werden die säure- beziehungsweise säureanhydridmodifizierten Elastomere und Epoxidharze in einem Mengenverhältnis eingesetzt, so dass der molare Anteil an Epoxidgruppen und Anhydridgruppen gerade äquivalent ist. Bei der Verwendung von nur gering modifizierten Elastomeren und dem Einsatz niedermolekularer Epoxidharze mit einem niedrigen Epoxidäquivalent ergeben sich dabei nur sehr geringe Mengen - von unter 10 Gew.-% bezogen auf das modifizierte Styrolblockcopolymer - an Epoxidharz, die eingesetzt werden.
Das Verhältnis zwischen Anhydridgruppen und Epoxidgruppen kann aber in weiten Bereichen variiert werden, dabei sollte für eine ausreichende Vernetzung keine der beiden Gruppen in mehr als einem vierfachen molaren Überschuss vorliegen.

Zur Herstellung des Klebebandes werden die Bestandteile der Klebmasse in einem geeigneten Lösungsmittel, zum Beispiel Toluol oder Mischungen aus Benzin 70/90 und Aceton, gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist auch möglich, die Klebmasse direkt auf einen Polyimidträger zu beschichten. Solche Klebfolien können dann zur Abdeckung von Kupferleiterbahnen für FPCBs eingesetzt werden.

Es ist nicht erforderlich, dass die Verklebung als einstufiges Verfahren erfolgt, sondern auf eines der beiden Substrate kann zunächst das Klebeband geheftet werden, indem man in der Wärme laminiert. Beim eigentlichen Heißklebeprozess mit dem zweiten Substrat (zweite Polyimidfolie oder Kupferfolie) härtet das Harz dann ganz oder teilweise aus, und die Klebstofffuge erreicht die hohe Verklebungsfestigkeit.
Die zugemischten Epoxidharze sollten vorzugsweise bei der Laminiertemperatur noch keine chemische Reaktion eingehen, sondern erst bei der Heißverklebung mit den Säure- oder Säureanhydridgruppen reagieren.

### Beispiele

Im Folgenden wird die Erfindung durch einige Beispiele näher beschrieben, ohne dabei die Erfindung in irgendeiner Weise zu beschränken.

### Beispiel 1

Eine Mischung aus 92,5 g Kraton™ FG 1901 (maleinsäureanhydridmodifiziertes Styrol-Ethylenbutylen-Styrol-Blockcopolymer mit 30 Gew.-% Blockpolystyrol und ca. 2 Gew.-% Maleinsäureanhydrid) und 7,5 g Bakelite™ EPR 191 (Epoxidharz) werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Beispiel 2

Eine Mischung aus 97,2 g Tuftec™ M 1913 (maleinsäureanhydridmodifiziertes Styrol-Ethylenbutylen-Styrol-Blockcopolymer mit 30 Gew.-% Blockpolystyrol und ca. 2 Gew.-% Maleinsäureanhydrid) und 2,8 g Polypox™ R 9 (Epoxidharzverdünner) werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Beispiel 3

Eine Mischung aus 87,4 g Kraton™ FG 1901, 2,6 g Bakelite™ EPR 161 (Epoxidharz) und 10 g Regalite™ R 1100 (hydriertes Kohlenwasserstoffharz mit einem Erweichungspunkt von ca. 100 °C der Firma Eastman) werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Vergleichsbeispiel 4

Eine Mischung aus 80 g Kraton™ G 1650 (nicht modifiziertes Styrol-Ethylenbutylen-Styrol-Blockcopolymer analog Kraton™ FG 1901), 14 g Bakelite™ EPR 161 und 6 g Maleinsäureanhydrid werden in Toluol gelöst und aus Lösung auf ein mit 1,5 g/m³ silikonisiertes Trennpapier beschichtet und bei 110 °C für 15 min getrocknet. Die Dicke der Klebeschicht beträgt 25 µm.

### Verklebung von FPCBs mit dem hergestellten Klebeband

Zwei FPCBs wurden jeweils mit den nach den Beispielen 1 bis 4 hergestellten Klebebändern verklebt. Dazu wurde das Klebeband auf die Polyimidfolie des FPCB-Laminats aus Polyimid/Kupferfolie bei 100 °C auflaminiert. Anschließend wurde eine zweite Polyimidfolie eines weiteren FPCBs auf das Klebeband geklebt und der ganze Verbund in einer beheizbaren Bürklepresse bei 200 °C bei einem Druck von 1,3 MPa für eine Stunde verpresst.

### Prüfmethoden

Die Eigenschaften der nach den oben genannten Beispielen hergestellten Klebstofffolien wurden mit folgenden Testmethoden untersucht.

### T-Peel Test mit FPCB

Mit einer Zugprüfmaschine der Firma Zwick wurden die nach dem oben beschriebenen Verfahren hergestellten Verbunde aus FPCB/Klebeband/FPCB im 180° Winkel mit einer Geschwindigkeit von 50 mm/min auseinander gezogen und die benötigte Kraft in N/cm gemessen. Die Messungen wurden bei 20 °C und 50% rel. Feuchte durchgeführt. Jeder Messwert wurde dreifach bestimmt.

### Temperaturbeständigkeit

Analog zum beschriebenen T-Peel Test wurden die nach dem oben beschriebenen Verfahren hergestellten FPCB-Verbunde so aufgehängt, dass die eine Seite des Verbundes aufgehängt wurde, an der anderen Seite wurde ein Gewicht von 500 g befestigt. Der statische Schältest findet bei 70 °C statt. Gemessen wird der statische Schälweg in mm/h.

### Lötbadbeständigkeit

Die nach dem oben beschriebenen Verfahren verklebten FPCB-Verbunde wurden für 10 Sekunden auf ein 288 °C heißes Lötbad gelegt. Die Verklebung wurde als lötbadbeständig gewertet, wenn sich keine Luftblasen bildeten, welche die Polyimidfolie des FPCBs aufblähen ließen. Der Test wurde als nicht bestanden gewertet, wenn bereits eine leichte Blasenbildung eintrat.

### Ergebnisse:

Zur klebtechnischen Beurteilung der obengenanten Beispiele wurde zunächst der T-Peel Test durchgeführt.

Die Ergebnisse sind Tabelle 1 zu entnehmen.

**Tabelle 1**

| | T-Peel Test [N/cm] |
|---|---|
| Beispiel 1 | 9,7 |
| Beispiel 2 | 9,3 |
| Beispiel 3 | 14,8 |
| Beispiel 4 | 3,2 |

Wie zu erkennen ist, konnten in den Beispielen 1 bis 3 sehr hohe Klebkräfte erreicht werden, während das Referenzbeispiel nur sehr niedrige Klebkräfte zeigt.

Die Temperaturbeständigkeit der Klebebänder wurde mit dem statischen Peel-Test gemessen, dessen Werte in Tabelle 2 zu finden sind.

**Tabelle 2**

| | Statischer T-Peel Test bei 70 °C [mm/h] |
|---|---|
| Beispiel 1 | 5 |
| Beispiel 2 | 7 |
| Beispiel 3 | 12 |
| Beispiel 4 | 36 |

Wie zu erkennen ist, ist bei dem Referenzmuster die Temperaturbeständigkeit deutlich niedriger als bei den Beispielen 1 bis 3.

Der Lötbadtest wurde von allen 4 Beispielen bestanden.

## Patentansprüche

1. Hitzeaktivierbares Klebeband für die Verklebung von elektronischen Bauteilen und Leiterbahnen mit einer Klebemasse, die zumindest aus
a) einem säure- oder säureanhydridmodifizierten Vinylaromatenblockcopolymer und
b) einer epoxidhaltigen Verbindung
besteht.

2. Hitzeaktivierbares Klebeband nach Anspruch 1, **dadurch gekennzeichnet, dass** es sich bei dem Vinylaromatenblockcopolymer um ein Styrolblockcopolymer handelt.

3. Hitzeaktivierbares Klebeband nach einem der vorigen Ansprüche, **dadurch gekennzeichnet, dass** die epoxidhaltige Verbindung ein Epoxidharz und/oder ein epoxidiertes Polymer ist.

4. Hitzeaktivierbares Klebeband nach einem der vorigen Ansprüche, **dadurch gekennzeichnet, dass** die Klebemasse klebrigmachende Harze, Beschleuniger, Farbstoffe, Ruß und/oder Metallpulver enthält.

5. Hitzeaktivierbares Klebeband nach einem der vorigen Ansprüche, **dadurch gekennzeichnet, dass** die Klebemasse bei Temperaturen über 150 °C vernetzt.

6. Hitzeaktivierbares Klebeband nach zumindest einem der vorigen Ansprüche, **dadurch gekennzeichnet, dass** die Klebmasse weitere Elastomere wie solche auf Basis reiner Kohlenwasserstoffe, chemisch im wesentlichen gesättigte Elastomere sowie chemisch funktionalisierte Kohlenwasserstoffe enthält.

7. Hitzeaktivierbares Klebeband nach einem der vorigen Ansprüche, **dadurch gekennzeichnet, dass** die Klebemasse weitere Säureanhydride enthält.

8. Hitzeaktivierbares Klebeband nach einem der vorigen Ansprüche, **dadurch gekennzeichnet, dass** der Anteil der Epoxidharze höchstens 10 Gew.-%, bevorzugt 5 Gew.-% bezogen auf den Anteil an säure- beziehungsweise säureanhydridmodifiziertem Elastomer beträgt.

9. Verwendung eines hitzeaktivierbaren Klebebands nach zumindest einem der vorigen Ansprüche zur Verklebung von Kunststoffteilen.

10. Verwendung eines hitzeaktivierbaren Klebebands nach zumindest einem der vorigen Ansprüche zur Verklebung von elektronischen Bauteilen und/oder von flexiblen gedruckten Schaltungen.

11. Verwendung eines hitzeaktivierbaren Klebebands nach zumindest einem der vorigen Ansprüche zur Verklebung auf Polyimid.
